# EUROPEAN PATENT SPECIFICATION

(11) **EP 1 530 411 B1**
(45) Date of publication and mention of the grant of the patent: **09.07.2008**
(21) Application number: 04023587.1
(22) Date of filing: 04.10.2004
(51) Int. Cl.: H05K 7/02, H05K 3/32

(54) **Circuit assembly, producing method of the same, distribution unit and bus bar substrate**
Schaltungsanordnung, Verfahren zu seiner Herstellung, Verteilungseinheit und Stromschiene
Ensemble de circuits ainsi que son procédé de fabrication, unité de distribution et substrat de barres omnibus

(30) Priority: 05.11.2003 JP 2003376109
(43) Date of publication of application: 11.05.2005
(73) Proprietor: Sumitomo Wiring Systems, Ltd., Yokkaichi-City, Mie, 510-8503 (JP)
(72) Inventor: Onizuka, Takahiro c/o Sumitomo Wiring Systems, Ltd., Yokkaichi-city Mie 510-8503 (JP); Kita, Yukinori c/o Sumitomo Wiring Systems, Ltd., Yokkaichi-city Mie 510-8503 (JP)
(74) Representative: Winter, Brandl, Fürniss, Hübner Röss, Kaiser, Polte Partnerschaft Patent- und Rechtsanwaltskanzlei

(56) References cited:
- EP-A- 0 804 054
- EP-A- 1 039 790
- EP-A- 1 119 225
- EP-A- 1 201 505
- EP-A- 1 215 755
- FR-A- 1 510 175
- US-A1- 2004 001 319

## Description

### 1. Field of Invention

This invention is directed to a circuit assembly and to a method of production in which a plurality of bus bars constituting an electrical power circuit are stacked through electrical insulation layers and to a circuit component for actuation in the electrical power circuit.

### 2. Description of Related Art

Recently, a number of electronic units are installed on a vehicle such as a motor vehicle and a distribution unit is generally used for distributing an electrical power from a common electrical source on a vehicle to the respective electronic units. A circuit assembly to be installed in the distribution unit has been known. Such circuit assembly, as disclosed in, for example, Japanese Patent Publication 2000-331759, includes a stacked circuit section (bus bar substrate) in *which bus* bars constituting an internal circuit are stacked through insulation plates at plural layers. *The* bus bar on a lower layer of the stacked circuit section is bent to form a tab terminal. The tab terminal is inserted into a receiving aperture in the stacked circuit section and projects from a front side of the aperture. A tab terminal of a relay is connected to the tab terminal of the bus bar through a junction terminal having a female type-coupling portion on the opposite ends, so that the relay is detachably connected to the internal circuit.

EP 1 215 755 A1 discloses a connecting structure of an electrical component to an electrical junction box. According to this document, long terminals from an electrical component (e.g. a relay) are bent towards an outer periphery of the electrical component and welded to a flat bus bar structure.

FR 1.510.175 discloses a device for interconnection of electronic components. According to the teaching of this patent, parallel connection terminals having a standard distance (e.g. 1,27 mm) between them are used to connect an electronic component with a bus bar layer having an isolation which is removed in equispaced gaps of said standard distance. The terminals are connected to the layers where th isolation is removed.

EP 0804 054 A1 discusses an insulated surface mount circuit board construction. According to this document, a multi-layer circuit board includes an insulated mounting area for a surface mount package which is provided in a recess of the board where the circuit board is only a single layer thick. On the backside of the recess, a heat sink can be mounted to effectively dissipate heat generated in the surface mount package.

### SUMMARY OF THE INVENTION

The occupation area for arranging the distribution unit on a vehicle body tends to be decreased every year. Consequently, the market encourages downsizing of the circuit assembly itself.

The bus bars in the distribution unit and circuit assembly disclosed in Japanese Patent Publication 2000-331759 are stacked through the insulation layers alternately at the plural levels, the occupation area in plan view can be made relatively small. However, there has been a limitation in reduction of a size in height because the respective tab terminals of the relay and bus bar are connected through the junction terminal. That is, the tab terminals of the relay and bus bar must be fitted into the female type connecting portions by a given length in order to interconnect the tab terminals correctly and positively. This limits reducing a size in height in conjunction with maintaining this correct and positive connection. Even if the respective tab terminals are connected by another joining means, it is necessary for the respective tab terminals to be joined over a given length in order to maintain a good connection between the tab terminals. Accordingly, it is difficult to reduce the height size by using the connection of the tab terminals.

In view of the above problems, an object of exemplary embodiments the invention is to provide a circuit assembly in which a size in height can be reduced in conjunction with maintaining compactness, especially small occupation area in plan view by a simple structure and to provide a distribution unit and the like in which the circuit assembly is installed.

A first aspect of the invention is directed to a circuit assembly comprising a bus bar substrate, including plural bus bar layers stocked alternately through electrical insulation layer, and a circuit component, as defined in claim 1.

Because leg-like terminals of the circuit component include contact pieces to be superposed on one of the bus bars along one of the layers of the bus bars and the contact pieces are joined to a bus bar on a bus bar bar layer lower than the uppermost bus bar layer, the height of the leg-like terminal of the circuit component can be reduced in comparison with the prior art in which the bus bar is bent to form a tab terminal and a tab terminal of the circuit component is joined to the tab terminal of the bus bar. Thus, the size of the circuit component can be reduced, especially the size in height, in conjunction with maintaining a small occupation area in plan view by a simple structure such as the contact piece. Accordingly, it is possible to downsize the circuit assembly and the distribution unit in which the circuit assembly is installed.

Since in the case of performing resistance welding on the contact piece a pair of welding electrodes merely clamp the contact piece together with the bus bar in a vertical direction, a working space for welding can be reduced. In comparison with the prior art in which the leg-like terminal and bus bar are bent up or down to form tab terminals, the tab terminals are superposed, and the superposed portions are clamped laterally by the electrodes to perform resistance welding, the working space can be reduced for resistance welding on the contact piece, thereby realizing a high density in arrangement of circuit components. When the contact piece is joined by welding to the bus bar, the heat radiation influence can be moderated in connection with actuation of the circuit component, rather than in soldering. This will be advantageous in designing to satisfy thermal requirements.

A concrete structure of the circuit component is not limited so long as the circuit component has a contact piece. For example, the circuit component may include a component body and leg-like terminals extending from a lower surface of the component body toward the bus bar, and a given portion of each leg-like terminal is bent in a direction parallel to the layer surface of the bus bar to form the contact piece. According to this structure, it is possible to provide the contact piece easily.

The type of welding of the contact piece is not limited, so long as a part of matrix materials to be welded can be melted and joined to each other. For example, electrodes for resistance welding clamp the matrix materials to melt and join parts of the materials.

According to the structure of the present invention, it is possible to effectively utilize a surface area of the insulation layer stacked in the bus bar to which the leg-like terminal is joined, to effectively arrange the bus bar on the upper layer within a limited area in conjunction with preventing a short circuit between the bus bar layers, and to further downsize the circuit component.

The circuit component is not limited, but is preferably a relay. The relay having good heat radiation will be more preferable than a semiconductor-switching device such as a field-effect transistor (FET) in the case of mounting the circuit components at a high density in arrangement.

Preferably, the contact piece is disposed on each of plural terminals. The bus bar layers, on which the contact pieces are superposed, include different circuit components. A section between the contact pieces of the circuit components is disposed with a stepped portion corresponding to that between the layer surfaces of the bus bar layers.

According to the above structure, the terminals of the circuit component will not be subject to unsuitable deformation regardless of the stepped portion between the layer surfaces of the bus bar layers on which the contact piece is superposed, thereby greatly decreasing stresses in the respective terminals.

In addition, a distribution unit according to exemplary embodiments of the invention comprises a circuit assembly and a heat radiation casing that contains the circuit assembly.

According to exemplary embodiments of the invention, because the circuit assembly can be downsized, the distribution unit can be also downsized in association with reduction of the circuit assembly. In addition, the heat radiation casing can enhance heat radiation effectiveness of the circuit assembly on which the circuit components are mounted at a high density in arrangement.

Another aspect of the invention is directed to a method for producing a circuit assembly as defined in claim 7.

Because insulation layers are stacked to cover the joining portion of the contact pieces after the terminal joining step, a short circuit does not occur even when an upper bus bar layer is arranged above the joining portion, the upper bus bar layer can be effectively disposed by effectively using the surface of the insulation layer, thereby producing a small size circuit assembly.

According to the method of the invention, the insulation layer having the terminal receiving-apertures is interposed between the two bus bar layers (stacking step) and the circuit component is joined to the respective bus bar layers (remaining terminal joining step). Then, the covering step is performed for stacking the insulation layer. Consequently, the terminal receiving-apertures for receiving the remaining leg-like terminals are also covered by the covering step and the bus bar can be disposed above the terminal receiving-apertures. Accordingly, the bus bars can be effectively arranged on the insulation layer, thereby downsizing the circuit assembly.

The terminal-joining step including the remaining terminal joining step is not limited to the above joining method. For example, the contact pieces may be joined to the bus bars by clamping the matrix materials to melt them by means of resistance welding.

Exemplary embodiments for a bus bar substrate include an electrical power circuit in which plural bus bar layers are stacked alternately through electrical insulation layers at plural levels. Each of the bus bar layers has plural bus bars arranged on the substantially same plane. Terminal receiving-apertures for receiving the contact pieces of the circuit component are disposed in an insulation layer higher than bus bars to which the contact piece is joined, when a contact piece of at least one of leg-like terminals of the circuit components that includes leg-like terminals having contact pieces to be superposed on the bus bars along a layer surface of the bus bars is welded and joined on bus bars on a layer lower than the uppermost layer.

According to exemplary embodiments of the invention, it is possible to produce the circuit assembly specified merely by welding the leg-like terminals of the circuit component through the terminal receiving-apertures, thereby enhancing efficiency in a mounting work of the circuit component.

Preferably, the terminal receiving-aperture is formed so that an electrode for resistance welding can be inserted. According to this structure, because the leg-like terminal is formed to be suitable for joining by welding as well as soldering, a relatively small terminal receiving-aperture can be formed. When joining by soldering, it is necessary to obtain a space for forming a fillet around a peripheral edge of the contact piece of the leg-like terminal in order to maintain a joining strength over a certain value. The terminal receiving-aperture will become large in connection with obtaining the space for the fillet. According to exemplary embodiments of the invention, because the leg-like terminal is joined to the bus bar by welding, a relatively small terminal receiving-aperture can be formed corresponding to a size of the leg-like terminal and to effectively dispose the bus bars on the upper layer within a limited area by effectively using a surface area of the insulation layer above the bus bar to be joined to the leg-like terminal.

In the bus bar substrate specified, at least three bus bar layers are disposed, and a rear side of a joining portion of a bus bar on which the leg-like terminal of the circuit component is joined in an intermediate layer is exposed through the electrode receiving-aperture for resistance welding in an insulation layer lower than the bus bar on the intermediate layer. It is necessary to clamp the portions to be joined from the front and rear sides by resistance welding. The above structure can join the circuit component on the bus bar on the intermediate layer correctly.

Exemplary embodiments of the invention are directed to a method for producing a circuit assembly that includes a bus bar substrate and a circuit component. The bus bar substrate includes an electrical power circuit in which plural bus bar layers are stacked alternately through electrical insulation layers at plural levels. Each of the bus bar layers has plural bus bars arranged on the substantially same plane. The circuit component is connected to the electrical power circuit through terminals thereof. The method includes a bus bar substrate forming step for forming a bus bar substrate; and a mounting step for stacking at least one leg-like terminal on a bus bar on a layer lower than the insulation layer of the bus bar substrate through a terminal receiving-aperture in the insulation layer and for joining the stacked portions by welding.

According to the method for producing another circuit assembly in accordance with exemplary embodiments of the invention, because the circuit component is joined to the bus bar by welding the stacked portions disposed along the layer surface of the bus bar layer, the circuit assembly can be produced to reduce a size in height. In addition, because the circuit component is mounted through the terminal receiving-aperture in the insulation layer, the circuit component can be mounted on the electrical power circuit after the bus bars and insulation layers are stacked at the given levels, thereby producing the circuit assembly effectively.

The welding in the above mounting step is not limited to concrete means so long as matrix materials are melted and joined. For example, resistance welding will be preferable for clamping the stacked portions and melting a part of the matrix materials.

The bus bar substrate-forming step includes an insulation layer-forming step for forming an insulation layer disposed with a terminal receiving-aperture into which a terminal of the circuit component is inserted at the given position. A bus bar stacking step for stacking the plural bus bar layers through the insulation layers alternately to form a bus bar substrate. The insulation layer-forming step forms plural insulation layers. The bus bar stacking step accords the terminal receiving-apertures in the insulation layers with one another and stacks the insulation layers so that the bus bars on the lower layer are exposed through the terminal receiving-apertures. The mounting step joins the contact piece of at least one terminal to the bus bar on the lower layer.

According to the above structure, the mounting work can be effectively performed, even if the bus bars on the lower layers are stacked through the plural insulation layers. For example, although it is possible to use a semiconductor-switching device such as an FET in the case of using a switching device for turning an on-off mode of a circuit as the circuit component to be mounted in the mounting step, it is preferable to use a relay having heat radiation better than the semiconductor-switching device.

According to the circuit assembly of the present invention, the size in height of the circuit component can be reduced in conjunction with maintaining a small occupation volume, especially an occupation area by a simple structure, thereby downsizing the distribution unit in which the circuit assembly is installed.

According to the method for producing the circuit assembly of the invention, the insulation layers are stacked to cover the leg-like terminal of the circuit component that radiates heat and the upper bus bar layer can be effectively disposed. By effectively using the surface of the insulation layer, the bus bars can be effectively disposed on an upper layer within a limited area, thereby producing a small size circuit assembly.

Furthermore, the method facilitates efficiently producing the circuit assembly constructed above by dividing the assembling step into the bus bar stacking step and the mounting step.

### BRIEF DESCRIPTION OF THE DRAWINGS

The accompanying drawings, which are incorporated into and constitute a part of the specification, illustrate one or more embodiments of the invention and, taken with the detailed description, serve to explain the principles and implementations of the invention. In the drawings:
Figure 1 is a perspective view of a distribution unit in accordance with an embodiment of the invention, illustrating the unit in an inverted position.
Figure 2 is an exploded perspective view of the distribution unit shown in Figure 1.
Figure 3 is an exploded perspective view of a circuit assembly of the distribution unit.
Figure 4 is a cross sectional view of the distribution unit taken along line IV-IV in Figure 1.
Figure 5 is a longitudinal sectional view of the distribution unit taken along line V-V in Figure 1.
Figure 6 is a longitudinal sectional view of the distribution unit taken along line VI-VI in Figure 1.
Figures 7A to 7D are explanatory views of steps for producing a bus bar substrate in the distribution unit in accordance with an embodiment of the invention.
Figure 8 is an explanatory view of a step for mounting circuit components on the bus bar substrate.
Figure 9 is an explanatory view of a step for attaching the respective mounting sections to the bus bar substrate.
Figures 10A and 10B are cross and longitudinal sectional views of a lower casing to be used in the distribution unit of an embodiment of the invention.
Figures 11A and 11B are explanatory views of steps for installing a control circuit substrate on the bus bar substrate in the distribution unit.
Figure 12 is an explanatory view of a step for installing an upper casing on the lower casing in the distribution unit.
Figure 13 is a sectional view of a completed distribution unit taken along a plane different from that of Figure 4.
Figure 14 is a cross sectional view of another embodiment of a distribution unit in accordance with an embodiment of the invention, illustrating the sectional view similar to Figure 4.
Figure 15 is a partial sectional view of the distribution unit corresponding to Figure 6.
Figures 16A to 16D are explanatory views of steps for joining and stacking terminals in the distribution unit.
Figures 17A to 17C are explanatory views of steps for joining and stacking terminals in the distribution unit.
Figure 18 is a sectional view of the distribution unit, illustrating a position of a circuit component mounted on the bus bar substrate.

### DETAILED DESCRIPTION OF EXEMPLARY EMBODIMENTS

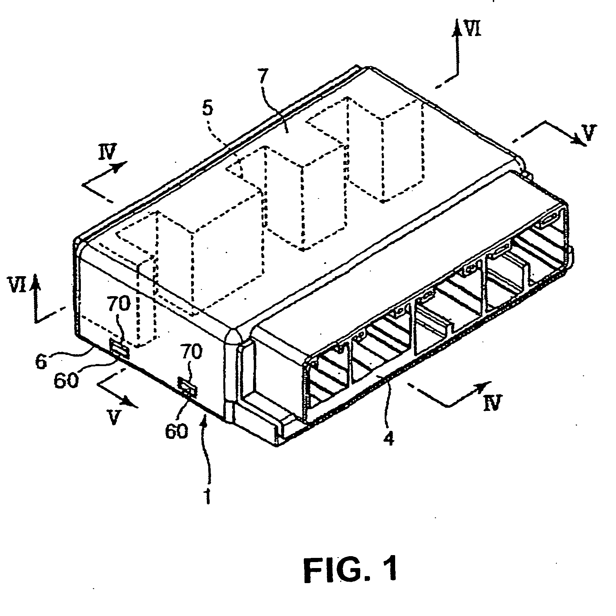

Referring now to the drawings, a first embodiment of a distribution unit in accordance with the invention will be described below. A circuit assembly and an a distribution unit are described here which includes distribution circuits for distributing an electrical power supplied from a common power source mounted on a vehicle to a plurality of electrical loads (for example, a head light unit, a small light unit, a hom unit, a washer unit, and the like). However, the circuit assembly and distribution unit of the invention are not limited to the above applications. They can be broadly used to an on-off switching application in which conduction in an electrical power circuit is carried by a circuit component such as a relay. Such a circuit assembly is installed in a distribution unit 1 shown in Figure 1. Figure 1 is a perspective view of the distribution unit 1 in accordance with the first embodiment of the invention, illustrating the unit in an inverted position.

The distribution unit 1 has a substantially rectangular parallelepiped configuration and is very compact although it has a function of distributing an electrical power to a plurality of electrical loads (five electrical units in the first embodiment). In the first embodiment, the distribution unit 1 can be contained in a space having a longitudinal side of 75 mm, a lateral side of 100 mm, and a height of 25 mm.

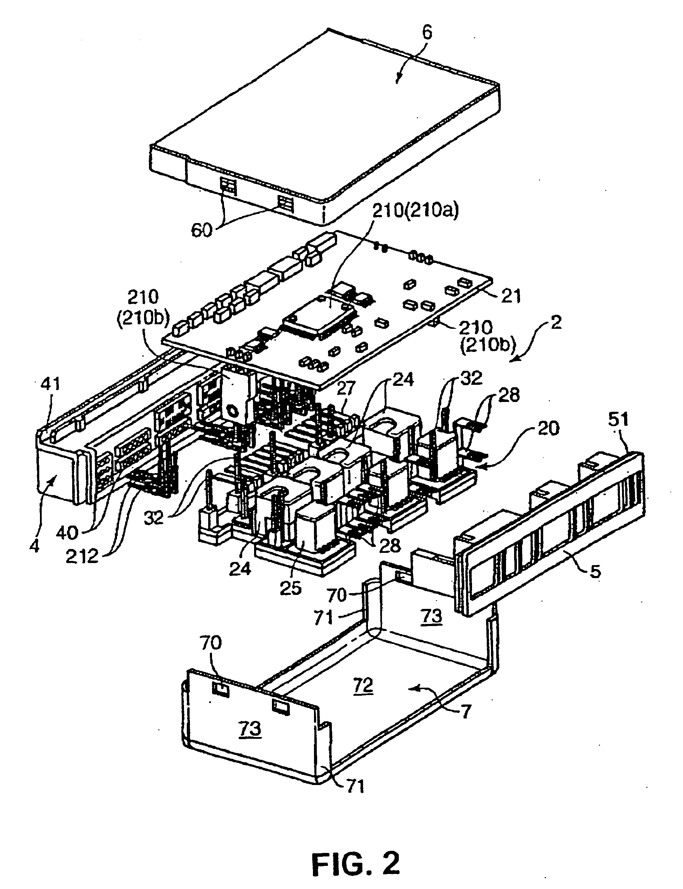

The distribution unit 1, as shown in Figure 2, comprises a circuit assembly 2 including a control circuit substrate 21, a connector mounting section 4 and a fuse mounting section 5 that are secured to the circuit assembly 2, and an upper casing 6 and a lower casing 7 that contain the circuit assembly 2 supporting the mounting sections 4 and 5 with the casings 6 and 7 clamps the circuit assembly 2 in a vertical direction so that the mounting sections 4 and 5 are exposed. For the convenience of explanation, the words "front side" and "vertical direction" in the specification define a side on which the connector mounting section 4 is formed in the distribution unit 1 and a height direction in Figure 2, respectively.

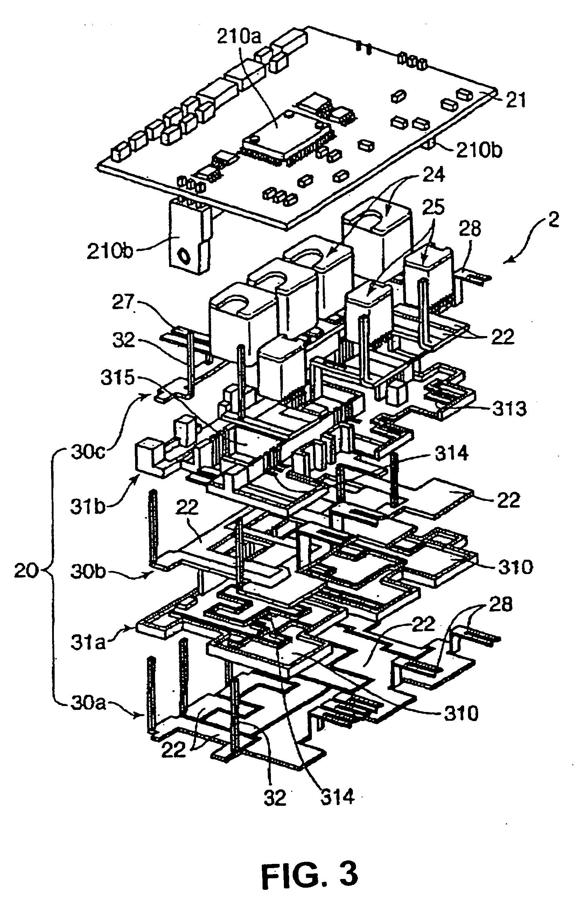

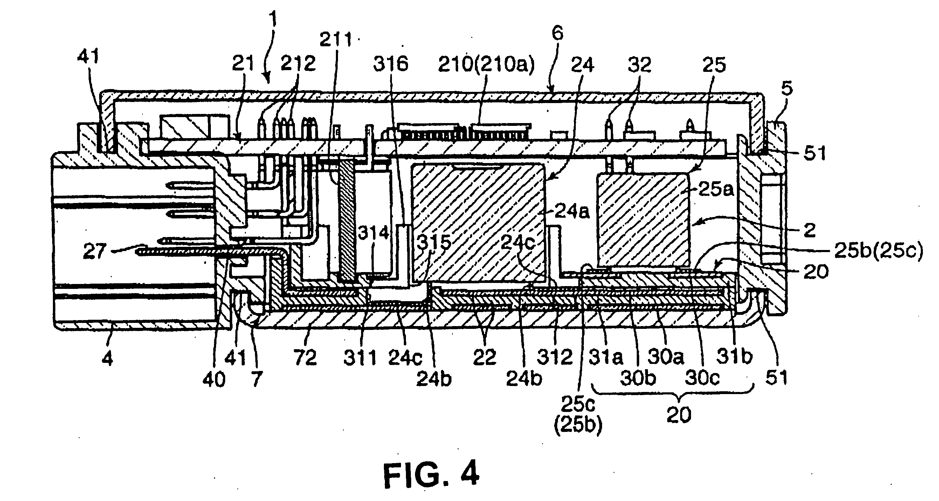

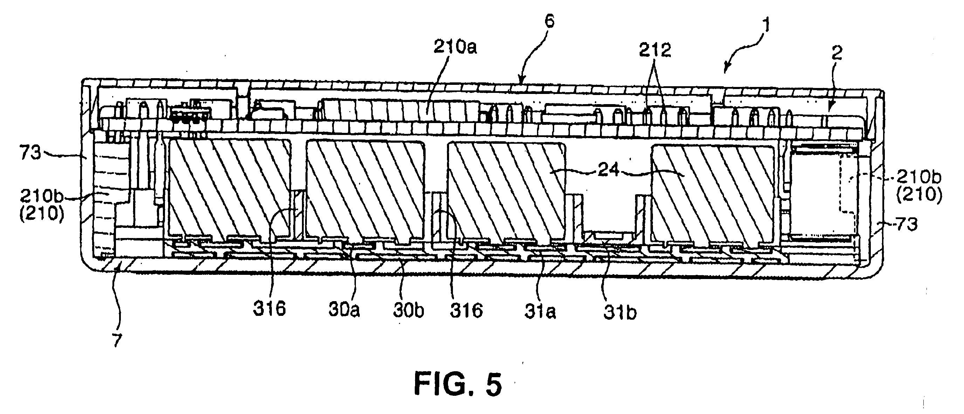

Figure 3 is an exploded perspective view of the circuit assembly 2 of the distribution unit 1. Figures 4 to 6 are sectional views of the distribution unit 1 taken along lines IV-IV, V-V, and VI-VI in Figure 1.

The circuit assembly 2 includes electrical power circuits for distributing a common electrical power source on a vehicle to the respective electrical loads under a predetermined condition. The circuit assembly 2 comprises a bus bar substrate 20 in which a plurality of bus bar layers 30 each including a plurality of bus bars 22 juxtaposed on the substantially same plane are stacked through insulation plates 31 alternately at a plurality of levels, two kinds of relays 24 and 25 as electrical power components mounted on the bus bars 22 on the bus bar substrate 20, and a control circuit substrate 21 disposed above the bus bar substrate 20 to interpose the relays 24 and 25 between the substrates 20 and 21.

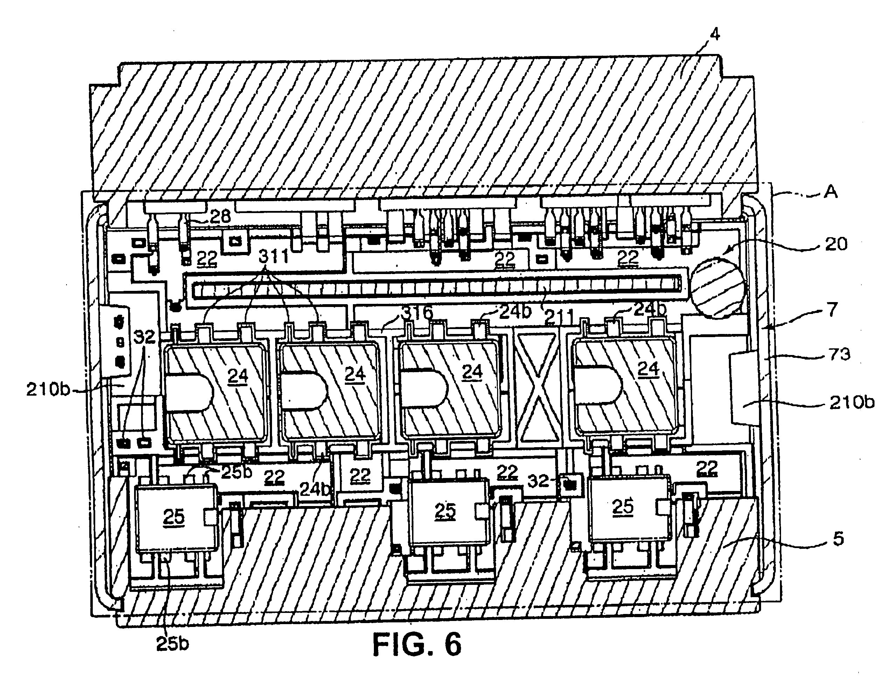

The circuit assembly 2 is formed into a flat block configuration having a substantially rectangular parallelepiped configuration. A number of connector terminals 27 having the given bus bars 22 bent in a hook-like shape are juxtaposed and projected forward from a square flat area A (see Figure 6) at the front side of the circuit assembly 2. A plurality of fuse terminals 28 having the given bus bars 22 bent in a hook-like shape are substantially contained in the square flat area A and projected rearward in two stages at the rear side of the circuit assembly 2. A plurality of first relays 24 (four in the first embodiment) are mounted along a longitudinal direction (right and left direction) on the upper surface of the bus bar substrate 20 between the connector terminals 27 and the fuse terminals 28. One or more of the fuse terminals 28 are disposed closely to one another on the circuit assembly 2. Second relays 25 are mounted between the compacted fuse terminals 28 on the upper surface of the bus bar substrate 20.

To be more specific, the bus bar substrate 20 includes a plurality of bus bar layers 30a to 30c. Each of insulation plates (insulation layers) 31 a and 31b is interposed between the adjacent bus bar layers 30a to 30c. In the first embodiment, as shown in Figure 3, the first insulation plate 31a is disposed between the first and second bus bar layers 30a and 30b in conjunction with the second insulation plate 31b is disposed between the second and third bus bar layers 30b and 30c. Although the bus bar substrate 20 having the three stages including the bus bar layers 30a to 30c is used in the first embodiment, the number of the stacking layers is not limited to the three stages, so long as the stacking layers are plural layers.

A plurality of bus bars 22 are arranged in a given pattern on the substantially same plane of each of the bus bar layers 30a to 30b, as described above. The given bus bar 22 is bent vertically and a distal end of the bent bus bar is further bent in a horizontal direction to form the connector terminal 27 or the fuse terminal 28 in a hook-like configuration. A pin-like terminal 32 is formed by bending the given bus bar 22 in each of the bus bar layers 30a to 30c so that the pin-like terminal 32 projects from the upper surface of the first relay 24 or the second relay 25. The distal end of the pin-like terminal 32 is connected to a control circuit of the control circuit substrate 21. Electrical signals are transmitted through the pin-like terminal 32 from the control circuit substrate 21 to control an actuation of the first and second relays 24 and 25 disposed on the given bus bar layers 30a to 30c.

The first and second relays 24 and 25 are mechanical type relays and include relay bodies 24a and 25a having substantially rectangular parallelepiped configurations and a plurality of flat plate leg-like terminals 24b and 25b, respectively. The leg-like terminals 24b of the first relay 24 extend downward from a lower surface of the relay body 24a and are bent along the bus bar layer 30 to be formed into contact pieces 24c to be superposed on the given bus bar 22. Particularly, the leg-like terminal 24b of the first relay 24 in the first embodiment is bent at the end near the relay body 24a side to become a whole height of the first relay 24 including the leg-like terminal 24b as low as possible. In addition, the second relay 25 has leg-like terminals 25b that extend from a lower surface of a relay body 25a along the bus bar layer 30. Thus, the leg-like terminals 25b define contact pieces 25c to be superposed on the given bus bar 22 in the third bus bar layer 30c. Because the entire leg-like terminals 25b of the second relay 25 serve as contact pieces 25c, a whole height of the second relay 25 becomes as low as possible.

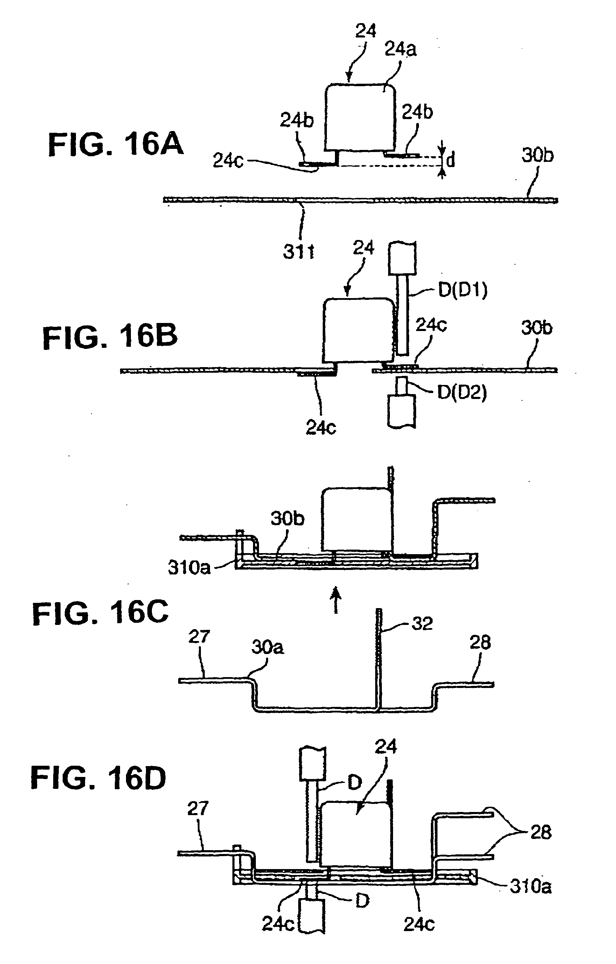

To be more specific, the first relay 24 is mounted on the lowermost layer or the first bus bar layer 30a and on an intermediate layer or the given bus bar 22 of the second bus bar layer 30b. Accordingly, the leg-like terminals 24b of the first relay 24 include the contact piece 24c to be superposed on the bus bar 22 of the first bus bar layer 30a and the contact piece 24c to be superposed on the bus bar 22 of the second bus bar layer 30b. The first relay 24 corresponds to a circuit component. A stepped portion d (see Figure 16A) between the respective leg-like terminals 24b corresponding to the respective bus bar layers 30a and 30b is disposed in the substantially same manner as a stepped portion between the first and second bus bar layers 30a and 30b. Thus, if the stepped portion d is disposed between the leg-like portions 24b by the bus bar layers 30a and 30b to be joined, the leg-like terminals of the first relay 24 are not forcedly deformed regardless of the stepped portion between the layer surfaces and stresses exerted in the respective leg-like terminals can be greatly reduced.

In addition, the whole height of the second relay 25 is lower than that of the first relay 24. The second relay 25 is mounted on the bus bar 22 of the uppermost layer or the third bus bar layer 30c and has a contact piece 25c over the entire length thereof, thereby reducing the whole height of the second relay 25 as low as possible. In the real mounting state, the top of the second relay 25 is lower than that of the first relay 24.

The first and second relays 24 and 25 are connected to the given bus bars 22 at the contact pieces 24c and 25c by welding. In the first embodiment, the portions to be joined are welded by a resistance welding method in which a pair of electrodes clamp portions and a high current are supplied to the electrodes to generate resistance heat in matrix materials. The welding method is not limited to the resistance welding method so long as the matrix materials are welded and joined by any welding method such as a laser welding method. Thus, greater strength can be obtained in joining between the first and second relays 24 and 25 by a welding method than a soldering method.

Further, heat resistance can be enhanced in the joining portion and to obtain a positive joining. In addition, because it is not necessary to provide fillets, the distance interval between the superposed layers can be shortened. Because it is not necessary to form a space for containing the fillets, it is also possible to make a first terminal receiving-aperture relatively small and to make the circuit assembly 2 compact by using a broadened bus bar arrangement area.

The first and second relays 24 and 25 are mounted on the bus bar substrate 20 after the bus bar substrate 20 is formed. A concrete mounting method will be described after.

In addition, the insulation plates 31a and 31b serve to prevent a short circuit between the bus bars 22 arranged on the bus bar layers 30a to 30c as well as a short circuit among the bus bar layers 30a, 30b, and 30c. The insulation plates 31a and 31b are formed into flat plates made of an electrically insulation material.

The first insulation plate 31 a interposed between the first bus bar layer 30a and the second bus bar layer 30b disposed above the first bus bar layer 30a are disposed in the upper and lower surfaced (front and rear sides) with bus bar containing-grooves 310 (see Figure 3) that receive the respective bus bars 22 on the first and second bus bar layers 30a and 30b individually. The respective bus bars 22 are contained and positioned in the bus bar containing-grooves 310.

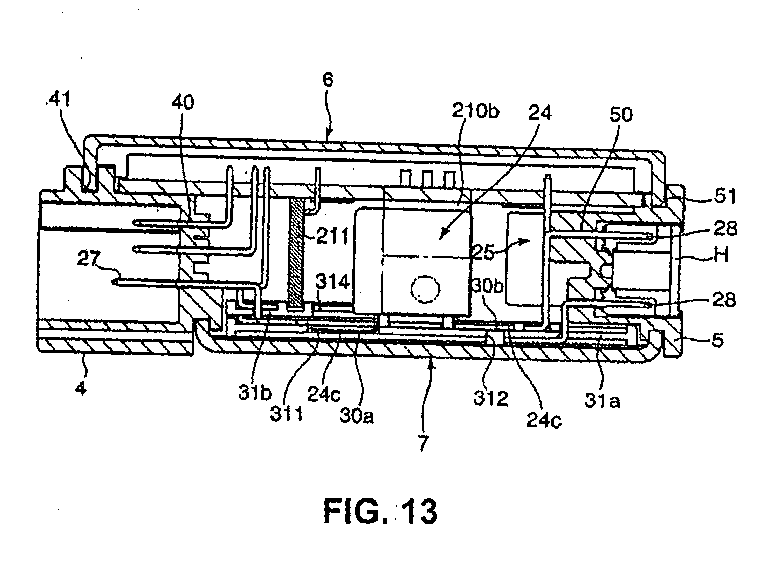

The first insulation plate 31 a is disposed in a given position with first terminal receiving-apertures 311 (see Figure 4) that pass the plate 31a in the thickness direction and receive leg-like terminals 24b to be joined to the bus bar 22 on the first bus bar layer 30a out of the leg-like terminals 24b of the first relay 24. The first terminal receiving-aperture 311 is formed into the substantially same shape as that of the leg-like terminal 24b of the first relay 24 and is set to be the substantially same size in a plan view. The first terminal receiving-aperture 311 is set to be a size enough to insert an electrode for resistance welding, so that the resistance welding can be performed by effectively using the first terminal receiving-aperture 311. In the case of effecting resistance welding in a bus bar layer (the second bus bar layer 30b in the first embodiment) above the first insulation plate 31a, an electrode receiving-aperture 312 (see Figure 13) is disposed in the first insulation plate 31a so that a lower electrode can contact with the given bus bar 22 on the second bus bar layer. A portion of the given bus bar 22 on the second bus bar layer 30b (a portion to be joined to the right leg-like terminal 24b of the first relay 24 in Figure 4) is exposed downward through the electrode receiving-aperture 312.

A second insulation plate 31b is interposed between the second bus bar layer 30b and a third bus bar layer 30c above the second bus bar layer 30b. The second insulation plate 31b is disposed in the upper (front) surface with bus bar containing-recesses 313 (see Figure 3) for containing the respective bus bars 22 on the third bus bar layer 30c individually to position the respective bus bars. The second insulation plate 31b is disposed in the given positions with second terminal receiving-apertures 314 (see Figure 3) that pass the plate 31 b in a thickness direction and receive the leg-like terminals 24b of the first relay 24. Some of the second terminal receiving-apertures 314 are communicated with the first terminal receiving-apertures 311 in the vertical direction with the respective insulation plates 31a and 31b being stacked. The joined potions of the given bus bar 22 on the first bus bar layer 30a are exposed through the communicated first and second terminal receiving-apertures 311 and 314.

In the first embodiment, the terminal receiving-apertures 311 and 314 are formed in the first and second insulation plates 31a and 31b to expose the joining portions of the given bus bars 22 on the bus bar layers. In the case where the bus bar 22 on the bus bar layer is disposed above or below the joining portions, a terminal receiving-aperture is also disposed in the bus bar additionally.

Electrodes of a certain welding machine are inserted into the first and second terminal-receiving apertures 311 and 314 and the electrode receiving-aperture 312 to clamp the joining portions. Then, a high current is supplied to the electrodes to mount the relay 24 on the bus bar substrate 20 by resistance heating.

Furthermore, a body receiving-aperture 315 (see Figures 3 and 4) is disposed in the second insulation plate 31b to be communicated with the second terminal receiving-aperture 314 to cause a relay body 24a of the first relay 24 to pass the aperture 315. The body receiving-aperture 315 is disposed around the peripheral edge with a surrounding rib 316 (see Figure 4).

In addition, the control circuit substrate 21 includes a control circuit for controlling actuation of the first and second relays 24 and 25 that are the circuit components, for example, a printed circuit substrate (conductors are arranged on an insulation plate to form a control circuit). The control circuit substrate 21 is a plate-like configuration slightly larger than the bus bar substrate 20 and includes a plurality of semiconductors 210 mounted on the front and rear sides (upper and lower surfaces in Figure 4), an auxiliary substrate 211 (see Figure 4) disposed on the rear side, and a connector pin-like terminal 212 connected to the control circuit.

To be more specific, the semiconductor 210 includes an LSI (large scale integrated circuit) 210a that is disposed on a substantially central part on the front surface of the control circuit substrate 21 and serves as a microprocessor and FETs 210b, each of them being disposed on the laterally opposite ends on the rear surface. The circuit components (the LSI 210a and FETs 210b), which generate a relatively great heating value due to their actuations, are arranged on a peripheral edge portion of the circuit assembly 2. Thus, because the circuit components that generate relatively higher heating values are disposed on a peripheral edge portion of the circuit assembly 2, this facilitates radiating heat and can enhance heat radiation efficiency in the circuit components. Further, a potting agent filled in the front side of the control circuit substrate 21 seals the LSI 210a in conjunction with each FET 210b is adhered to the lower casing 7 in a manner of transmitting heat, thereby further enhancing efficiencies of heat radiation of them.

The auxiliary substrate 211 includes a printed circuit substrate in the same manner as the control circuit substrate 21 and forms some of control circuits for controlling the various kinds of circuit components. The auxiliary substrate 211 is formed into a plate-like configuration and interposed between the bus bar substrate 20 and the control circuit substrate 21. The auxiliary substrate 211 is arranged along the longitudinal direction of the control circuit substrate 21. Some of the control circuits to be formed on the control circuit substrate 21 are formed on the auxiliary substrate 211. By disposing the auxiliary substrate 211 between the bus bar substrate 20 and the control circuit substrate 21 in perpendicular to the respective substrates 20 and 21, the circuit assembly 2 can be made compact in conjunction with effectively using a space between the respective substrates 20 and 21 on which the first and second relays 24 and 25 are disposed. It is possible to optionally omit the auxiliary substrate 211. In this case, all of the control circuits are formed on the control circuit substrate 21.

The control circuit substrate 21 is provided in the given positions with through-holes (not shown). A pin-like terminal 32 standing from the bus bar 22 and a connector pin-like terminal 212 are inserted into the through-holes and their ends are joined to the control circuit substrate 21 by soldering.

In addition, the connector mounting section 4 is made of a resin material and has the same height and lateral length as those of the circuit assembly 2. The connector mounting section 4 is disposed with connector terminal receiving-apertures 40 (see Figure 2) for receiving the connector terminal 27 and a connector pin-like terminal 212. The respective ends of the connector terminal 27 and connector pin-like terminal 212 project through the connector terminal receiving-apertures 40 into the connector mounting section 4 so that the ends can be connected to external connectors. The connector mounting section 4 is disposed in the peripheral portion with a casing fitting-groove 41. When the respective front end edges of the upper and lower casings 6 and 7 are fitted into the casing fitting-groove 41, the connector mounting section 4 is incorporated with the casings 6 and 7.

In addition, the fuse mounting-section 5 is made of a resin material and has the same height and lateral length as those of the circuit assembly 2. The fuse mounting-section 5 is disposed with fuse terminal receiving-apertures 50 (see Figure 13) for receiving the fuse terminals 28. Ends of the fuse terminals 28 project through the fuse terminal receiving-apertures 50 into the fuse mounting-section 5 so that the ends of the terminals 28 can be connected to external connectors. The fuse mounting-section 5 is disposed in the peripheral portion with a casing fitting-groove 51. When the respective rear end edges of the upper and lower casings 6 and 7 are fitted into the casing fitting-groove 51, the fuse mounting-section 5 is incorporated with the casings 6 and 7 so that a main part of the fuse mounting-section 5 is contained in the casings 6 and 7.

The upper casing 6 is formed into a dish-like configuration that has a substantially rectangular shape in plan view and is open downward. A potting agent such as silicone resin is filled in the upper casing 6 previously, so that the various kinds of circuit components including the LSI 210a mounted on the front side (upper surface) of the control circuit substrate 21 are sealed. The upper casing 6 is disposed on the right and left side surfaces with a pair of front and rear engaging bulge portions 60. The lower casing 7 is disposed in the right and left sidewalls with engaging holes 70. When the bulge portions 60 are fitted into the engaging holes 70, the upper and lower casings 6 and 7 are interlocked with the casings 6 and 7 containing the circuit assembly 2.

The lower casing 7 is formed into a box-like configuration that is open upward. The lower casing 7 is made of a material having a good heat conduction property, such as an aluminum base metal in the same manner of the upper casing 6. The lower casing 7 is cut out at a substantially whole of the front and rear sidewalls to form a cutout portion 71. The connector mounting section 4 and fuse mounting-section 5 are attached to the cutout portion 71. The circuit assembly 2 is adhered to an upper surface of a bottom wall 72 of the lower casing 7 with an adhesive having a good electrical insulation property, such as epoxy resin. The interior of the lower casing 7 is filled with a potting agent. The potting agent seals the leg-like terminals 24b and 25b of the first and second relays 24 and 25. The lower casing 7 is disposed in the right and left sidewalls with two pairs of front and rear engaging holes 70 into which the engaging bulge portions 60 are fitted.

Next, a method for producing the circuit assembly and distribution unit will be explained below. The first relay 24 is mounted on the bus bar substrate 20 in the first embodiment, after the respective bus bar layers 30a to 30c are stacked on one another to form the bus bar substrate 20. The second relay 25 is previously mounted on the given bus bar 22 on the third bus bar layer 30c and then the third bus bar layer 30c is stacked on the other bus bar layers 30a and 30b.

Firstly, upon producing the circuit assembly 2, the bus bar layers 30a to 30c are stacked on one another through the insulation plates 31a and 31b to form the bus bar substrate 20 (bus bar stacking step).

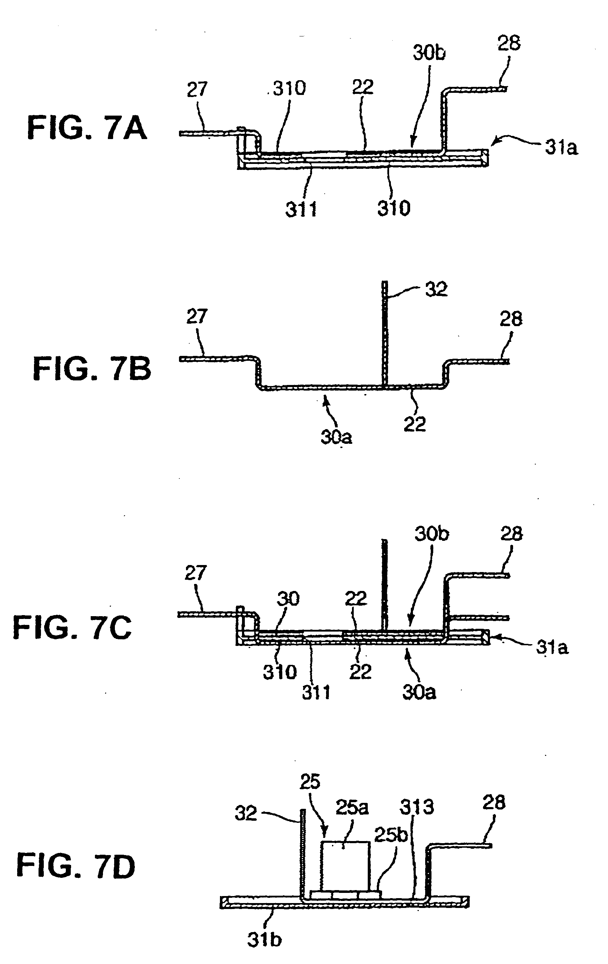

To be more specific, firstly, a first insulation plate 31a is formed, with the first terminal receiving-apertures 311, the electrode receiving-aperture 312, and the bus bar containing-recess 310 being disposed in the given positions (insulation layer forming step). A bus bar assembly (not shown) is formed by punching out a metallic plate so that the respective bus bars 22 are arranged in a given arrangement pattern on the second bus bar layer 30b, with the bus bars 22 being joined to an outer frame (not shown). The given bus bar 22 is bent to form a fuse terminal 28 or the like. The corresponding bus bar 22 is contained and fixed in the given bus bar containing-recess 310 in the front side (upper surface) of the first insulation plate 31 a. The connecting portions between the bus bars 22 and the outer frame are cut off and the second bus bar layer 30b is stacked on the first bus bar layer 30a (see Figure 7A).

Next, the first insulation plate 31 a, on which the second bus bar layer 30b is stacked, is stacked on the first bus bar layer 30a. That is, in the same manner as the second bus bar layer 30b, a bus bar assembly is formed so that the assembly has the given arrangement pattern of the bus bars corresponding to the first bus bar layer 30a. The given bus bar is bent to form the connector terminal 27 and the fuse terminal 28 (see Figure 7B). As shown in Figure 7C, the corresponding bus bar 22 is contained in the given bus bar containing-recess 310 in the rear side (lower surface) of the first insulation plate 31 a. The first insulation plate 31a is stacked on the first bus bar layer 30a. The respective bus bars 22 are adhered and fixed. The connecting portions between the bus bars 22 and the outer frame are cut off and the first and second bus bar layers 30a and 30b are stacked on each other through the first insulation plate 31a.

Then, a second insulation plate 31b is formed with a second terminal receiving-aperture 314, a body receiving-aperture 315, and a bus bar containing-recess 313 being disposed in the given positions (insulation layer forming step). Meanwhile, a bus bar assembly (not shown) is formed by punching out a metallic plate so that the respective bus bars 22 are arranged in a given arrangement pattern on the third bus bar layer 30c with the bus bars 22 being joined to an outer frame (not shown) (bus bar forming step). The given bus bar 22 is bent to form a connector terminal 27 and a fuse terminal 28.

In the first embodiment, a second relay 25 is previously mounted on the given bus bar 22 on the bus bar assembly, before the bus bar on the bus bar assembly corresponding to the third bus bar layer 30c is stacked on the second insulation plate 31b. That is, if the second relay 25 is mounted on the given bus bar 22 after the third bus bar layer 30c is stacked on the second insulation plate 31b, the second insulation plate 31b requires a hole for receiving an electrode for resistance welding. However, in the first embodiment, because the second relay 25 is mounted on the given bus bar 22 on the bus bar assembly, before the third bus bar layer 30c is stacked on the second insulation plate 31b, the second insulation plate 31 b requires no hole for receiving an electrode for resistance welding and it is possible to effectively utilize an arrangement area of the bus bar 22 on the second bus bar layer 30b that is stacked through the second insulation plate 31b on the third bus bar layer 30c. The second relay 25 may be mounted on the bus bar after the third bus bar layer 30c is stacked on the second insulation plate 31b, or after a stacked assembly including the third bus bar layer 30c and the second insulation plate 31b is stacked on another stacked assembly (including the first insulation plate 31 a, and the first and second bus bar layers 30a and 30b) to form a bus bar substrate 20. In this case, however, it is necessary to provide the first and second insulation plates 31a and 31 b with holes for receiving an electrode for resistance welding.

The contact pieces 25 of the leg-like terminal 25b of the second relay 25 are stacked on the given bus bar 22 on the third bus bar layer 30c, upper and lower electrodes D1 and D2 for resistance welding clamp the joining portions of the contact piece 25 and the bus bar 22, and the second relay 25 is welded on the third bus bar layer 30c by resistance welding.

Then, the corresponding bus bar 22 is contained and fixed in the given bus bar containing-recess 313 in the front side (upper surface) of the second insulation plate 31b. The connecting portions between the bus bars 22 and the outer frame are cut off and the third bus bar layer 30c is stacked on the second bus insulation plate 31b (see Figure 7D).

The stacked assembly including the third bus bar layer 30c and the second insulation plate 31 b is stacked on another stacked assembly including the first insulation plate 31a, and the first and second bus bar layers 30a and 30b to form a bus bar substrate 20. The second relay 25 has been mounted already on the bus bar substrate 20.

The bus bar substrate 20 constructed above exposes the connected portion between the leg-like terminal 24b and the bus bar 22 on the first bus bar layer 30a through the first and second terminal receiving-apertures 311 and 314 in the first and second insulation plates 31a and 31b in conjunction with the bus bar substrate 20 also exposes the connected portion between the leg-like terminal 24b and the bus bar 22 on the second bus bar layer 30b through the second terminal receiving-aperture 314 in the second insulation plate 31b. Thus, because the connected portion between the bus bars 22 on the first and second bus bar layers 30a and 30b and the leg-like terminals 24b of the first relay 24 is exposed through the first and second terminal receiving-apertures 311 and 314 in conjunction with the connected portion between the second bus bar layer 30b and the first relay 24 is exposed downward through the electrode receiving-aperture 312 in the first insulation plate 31a, the first relay can be mounted on the bus bar substrate 20 through the exposed portion by the following manner.

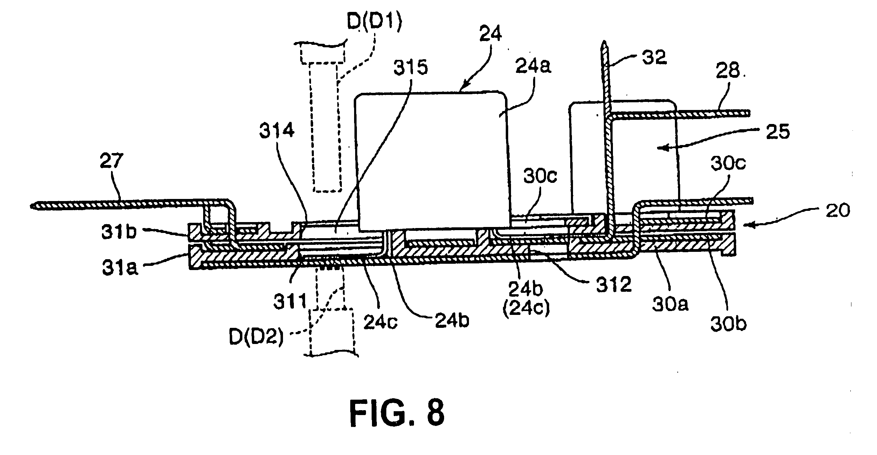

As shown in Figure 8, the first relay 24 is mounted on the bus bar substrate 20 as a circuit component (mounting step). Specifically, the leg-like terminal 24b of the first relay 24 is inserted into the first and second terminal receiving-apertures 311 and 314. The given contact piece 24c of the leg-like terminal 24b is stacked on the given bus bar 22. The electrodes D shown by dotted lines in Figure 8 clamp the stacked portion of the bus bar 22 and contact piece 24c to join them by resistance welding. The other contact piece 24c of the leg-like terminal 24b is stacked on the given bus bar on the second bus bar layer 30b. The electrodes D clamp the stacked portion of the bus bar 22 and contact piece 24c to join them by resistance welding. Upon the resistance welding, the upper electrode D1 is inserted into the first and second terminal receiving-apertures 311 and 314. Particularly, when the contact piece 24c is welded on the bus bar 22 on the second bus bar layer 30b, the lower electrode D2 is inserted into the electrode receiving-aperture 312 in the first insulation plate 31a.

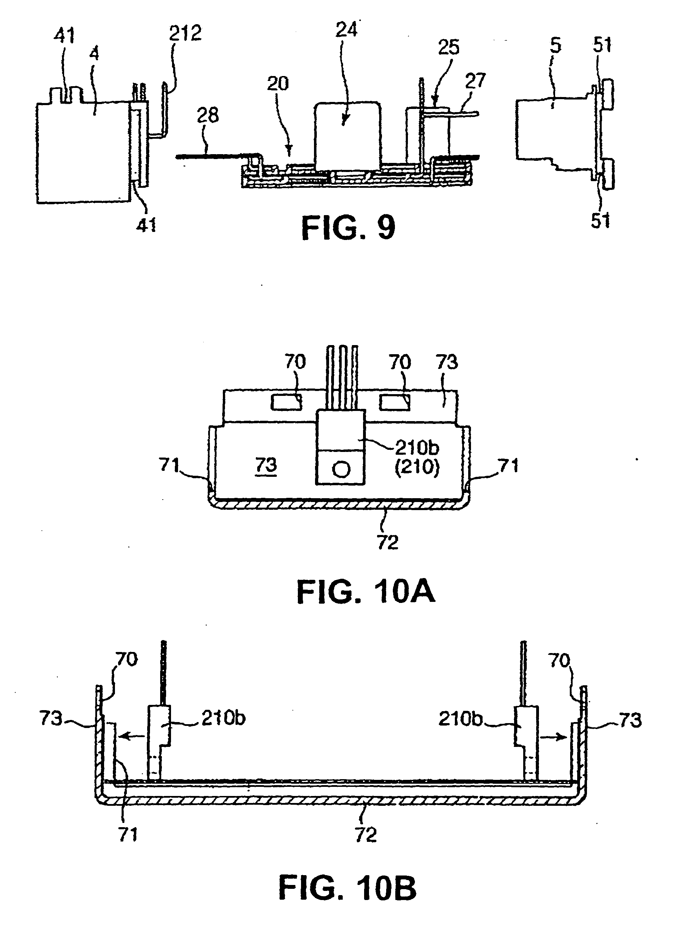

As shown in Figure 9, the connector mounting section 4 and fuse mounting-section 5 are attached to the bus bar substrate 20 on which the first and second relays 24 and 25 are mounted. To be more specific, the connector pin-like terminals 212 have been previously inserted into some of the connector terminal receiving-apertures 40 in the connector mounting section 4 in conjunction with the connector terminals 27 on the bus bar substrate 20 are inserted into the other connector terminal receiving-apertures 40. Then, the connector mounting section 4 is attached to a front end of the bus bar substrate 20. The fuse terminals 28 of the bus bar substrate 20 are inserted into the fuse terminal receiving-apertures 50 in the fuse mounting-section 5. Then, the fuse mounting-section 5 is attached to a rear end of the bus bar substrate 20.

After attaching the respective mounting-sections 4 and 5 to the bus bar substrate 20, the lower casing 7 shown in Figures 10A and 10B is attached to the bus bar substrate 20. In the first embodiment, in the attachment step of the lower casing 7, the FET 210b of the control circuit substrate 21 has been previously adhered to the given position on the inner surface of each of the right and left sidewalls 73 of the lower casing 7. Thus, because the FET 210b that generates heat in connection with actuation is attached to the lower casing 7 by an adhesive, the FET 210b and the lower casing 7 can be effectively interconnected with respect to a thermal action and to enhance efficiency in heat radiation of the FET 210b. Although the lower casing 7 is also used in the first embodiment in which the FET 210b is adhered to each of the right and left sidewalls 73, it should be noted that the circuit components and positions to be adhered are not limited to the above construction. They can be altered optionally in accordance with the circuit to be designed. In summary, any circuit components that generate heat in association with actuation can be previously attached to heat radiation members.

The lower casing 7 is attached to the bus bar substrate 20 by engaging the edge of the cutoff portion 71 of the lower casing 7 with the respective casing fitting grooves 41 and 51 in the connector mounting section 4 and fuse mounting section 5 attached to the bus bar substrate 20, and by joining the rear side (lower surface) of bus bar substrate 20 to an upper surface of a bottom wall 72 of the lower casing 7 by an adhesive. The adhesive having an electrical insulation property is used in the case where the lower casing 7 is made of an electrically conductive material. The adhesive including, for example, an epoxy base resin, a silicone base resin, or the like can be used. The lower casing 7 may be joined to the bus bar substrate 20 through, for example, an insulation layer such as an insulation plate attached to the rear side of the bus bar substrate 20 as well as the adhesive.

A potting agent is filled within the lower casing 7 by a given height to seal the leg-like terminals 24b and 25b of the first and second relays 24 and 25. The potting agent to be filled is preferably selected from a material having heat conductivity. The silicone base resin that has superior electrical insulation as well as heat conductivity can be used.

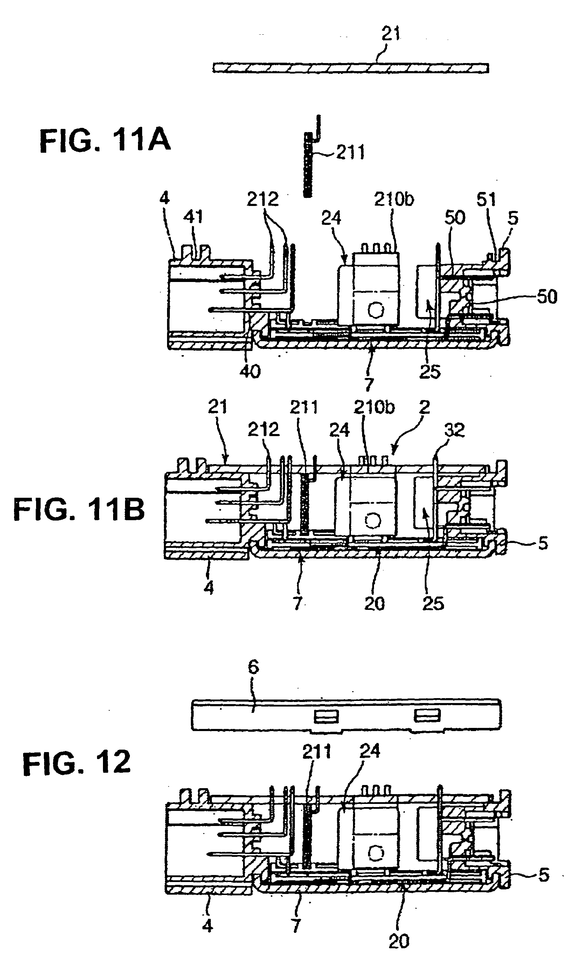

Next, as shown in Figures 11A and 11B, a control circuit substrate 21 is attached to the bus bar substrate 20 to form a circuit assembly 2. The control circuit substrate 21, on which various kinds of circuit components including an LSI 210a are mounted, is installed above the bus bar substrate 20 to establish a suitable electrical connection. To be more specific, the connector pin-like terminal 212 inserted into the connector terminal receiving-aperture 40 in the connector mounting section 4, the pin-like terminal 32 formed by bending the bus bar 22, and the FET 210b adhered to the lower casing 7 are suitably connected to the electrical circuits including a control circuit on the control circuit substrate 21. The control circuit substrate 21 is installed on the bus bar substrate 20 with the front and rear end edges of the control circuit substrate 21 being supported on upper surfaces of the connector mounting section 4 and fuse mounting-section 5. An auxiliary substrate 211 is attached to the rear side of the control circuit substrate 21 to be connected electrically. In the circuit assembly 2 constructed above, the bus bar substrate 20 is spaced away from the control circuit substrate 21 by a given distance. The first and second relays 24 and 25 are disposed at a high density in arrangement between the substrates 20 and 21.

Finally, as shown in Figure 12, the upper casing 6 is mounted on the lower casing 7 to produce the distribution unit 1. To be more specific, a potting agent is previously filled within the upper casing 6 and hardened to have a certain shape retention and flexibility property. Then the upper casing 6 is installed on the lower casing 7. The potting agent is selected from a material having superior heat conductivity. For example, a silicone base resin is preferable, because it has superior electrical insulation as well as heat conductivity.

Upon assembling the upper and lower casings 6 and 7, the front and rear end edges of the upper casing 6 are engaged with the casing fitting-grooves 41 and 51 in the connector mounting section 4 and fuse mounting-section 5, the upper casing 6 is fitted into the right and left sidewalls 73 of the lower casing 7, and the engaging bulge 60 of the upper casing 6 is fitted into the engaging hole 70 in the lower casing 7.

A fuse H is mounted on the fuse mounting-section 5 to form the distribution unit 1 shown in Figure 13. According to the circuit assembly 2 constructed above and the distribution unit 1 incorporating the assembly 2, because the bus bar layers 30a to 30c are stacked through the insulation plates 31a and 31b alternately at the plural levels, it is possible to reduce occupation of area in comparison with a electrical power circuit using a single bus bar layer. Further, because the first relay 24 that is highest in the circuit components is joined to the bus bars 22 on the first and second bus bar layers 30a and 30b below the uppermost third bus bar layer 30c and the contact pieces 24c of the leg-like terminals 24b of the first relay 24 is joined to the bus bars 22, it is possible to dramatically reduce a dimension in height in comparison with a prior art circuit assembly and distribution unit in which tab terminals are joined to each other.

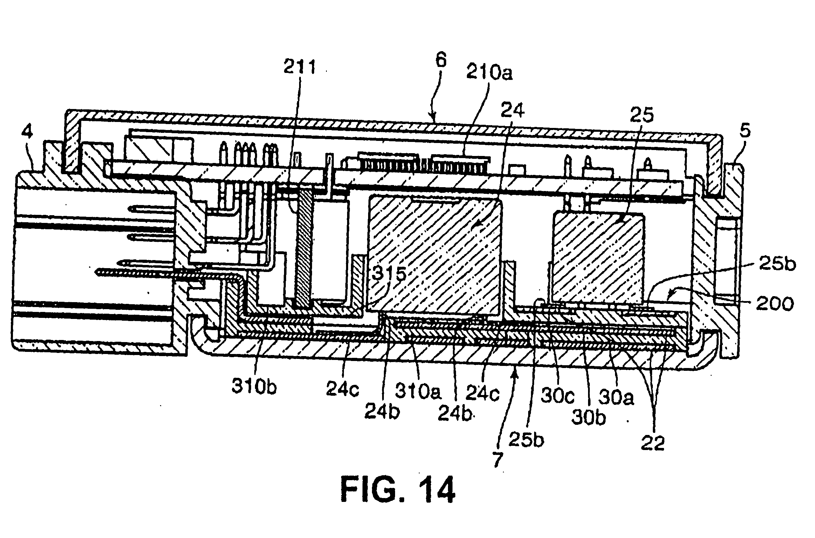

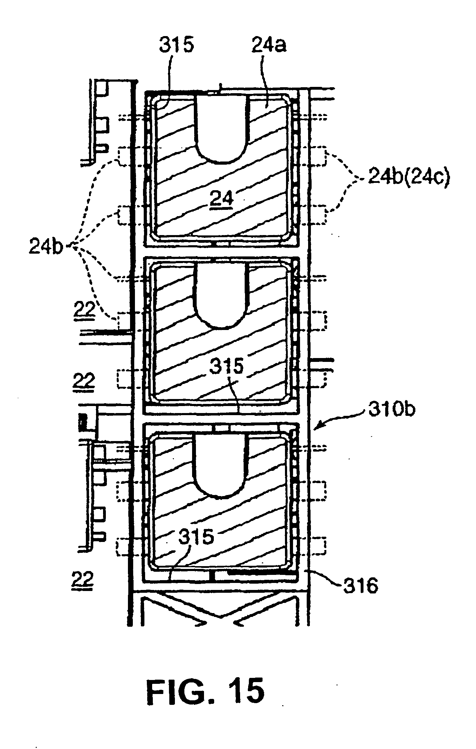

Figure 14 is a cross sectional view of a second embodiment of a distribution unit in accordance with the invention, illustrating the view similar to Figure 4. Figure 15 is a partial sectional view of the distribution unit corresponding to Figure 6.

A circuit assembly of the second embodiment is significantly different from that of the first embodiment with respect to the fact that a first relay 24 is joined to the bus bars 22 on lower layers (first and second bus bar layers 30a and 30b) below the uppermost third bus bar layer 30c, a second insulation plate 310b is stacked on a contact piece 24c of a leg-like terminal 24b of the first relay 24 so that the second insulation plate 310b covers a connected portion between the bus bar 22 and the contact piece 24c, and the bus bars on a third bus bar layer 30c are disposed on the second insulation plate 310b. Consequently, a method for producing the circuit assembly 2 of the second embodiment is different from that of the first embodiment. Thus, an electrode receiving-aperture for resistance welding is not disposed in the first insulation plate 310a. The other structures are the substantially same as those of the first embodiment. The different structures between them will be mainly described below.

A circuit assembly 200 in the second embodiment is significantly different from that in the first embodiment with respective to a second insulation plate 310b. The second insulation plate 310b is not provided with terminal receiving-apertures into which the leg-like terminal 24b of the first relay 24 is inserted. Consequently, the contact pieces 24c of the leg-like terminals 24b of the first relay 24 are covered by the second insulation plate 310b at the upper position thereof and the given bus bar 22 on a third bus bar layer 30c is disposed on the second insulation plate 310b. Namely, because the second insulation plate 310b is stacked on the contact pieces 24c, the third bus bar layer 30c can be disposed in an area above the bus bar 22 joined to the leg-like terminal 24b of the first relay 24 in the second insulation plate 310b, thereby widening an arrangement area of bus bars on the second insulation plate 310b. Consequently, a short circuit can be prevented between the first and second bus bar layers 30a and 30b and the third bus bar layer 30c, and simultaneously to further downsizes the circuit assembly 2 by effectively arranging the bus bars.

Next, a method for producing the circuit assembly 200 of the second embodiment will be described below. Because a method for producing a distribution unit 100, in which the circuit assembly 2 is installed, is the same as that of the first embodiment, an explanation of the method for producing the distribution unit will be omitted here.

In the method for producing the circuit assembly 200 in the second embodiment, the bus bar layers 30a to 30c are stacked through the first and second insulation plates 31a and 31b in conjunction with mounting the first and second relays 24 and 25, which serve exclusively as circuit components, on the bus bar substrate 20. The method in the second embodiment differs from the method in the first embodiment in which the first and second relays are mounted on the bus bar substrate 20 after the substrate 20 has been produced.

A bus bar assembly is produced, for example, by punching out a metallic plate so that each of the bus bar layers 30a to 30c is joined to each of outer frames (bus bar layer forming step). As shown in Figure 16A, the leg-like terminal 24b of the first relay 24 is joined to the bus bar 22 of the bus bar assembly corresponding to the second bus bar layer 30b (terminal joining step). To be more specific, as shown in Figure 16B, the contact piece 24b (right side contact piece 24 in Figure 16B) out of the contact pieces 24c of the first relay 24 is superposed on the given bus bar 22 on the second bus bar layer 30b. The electrodes D for resistance welding clamp the contact piece 24c and the given bus bar 22 to join the leg-like terminal 24b of the first relay 24 on the given bus bar 22 by resistance welding.

Next, the given bus bars 22 of the bus bar assembly corresponding to the second bus bar layer 30b is bent to form the respective terminals 27 and 28. The given bus bars 22 are contained in and adhered to the corresponding bus bar containing-grooves 310 in the front side (upper surface) of the first insulation plate 310a. The connecting portions between the bus bar 22 and the outer frame on the bus bar assembly are cut off. The second bus bar layer 30b, to which the first relay 24 is joined, is stacked on the first insulation plate 310a. At this time, the remaining leg-like terminals 24b out of the leg-like terminals 24b of the first relay 24, which are not joined to the second bus bar layer 30b, are inserted into the first terminal receiving-apertures 311 in the first insulation plate 310a.

As shown in Figure 16C, the bus bar assembly corresponding to the first bus bar layer 30a is installed on the first insulation plate 310a (stacking step). To be more specific, the given bus bar 22 of the bus bar assembly corresponding to the first bus bar layer 30a is bent to form the connector terminal 27. The bus bar assembly corresponding to the first bus bar layer 30a is installed on the first insulation plate 310a from a lower position. The connecting portions between the bus bars 22 and the outer frame on the bus bar assembly are cut off. The first and second bus bar layers 30a and 30b are stacked through the first insulation plate 310a. At this time, the remaining leg-like terminals 24b out of the leg-like terminals 24b of the first relay 24, which have not been joined to the second bus bar layer 30b, stack the contact pieces 24c on the given bus bars 22 on the first bus bar layer 30a.

Then, as shown in Figure 16D, the electrodes D for resistance welding clamp the contact piece 24c of the remaining leg-like terminal 24b of the first relay 24 and the given bus bar 22 on the first bus bar layer 30a to join the remaining leg-like terminal 24b of the first relay 24 to the first bus bar layer 30a by resistance welding (remaining terminal joining step).

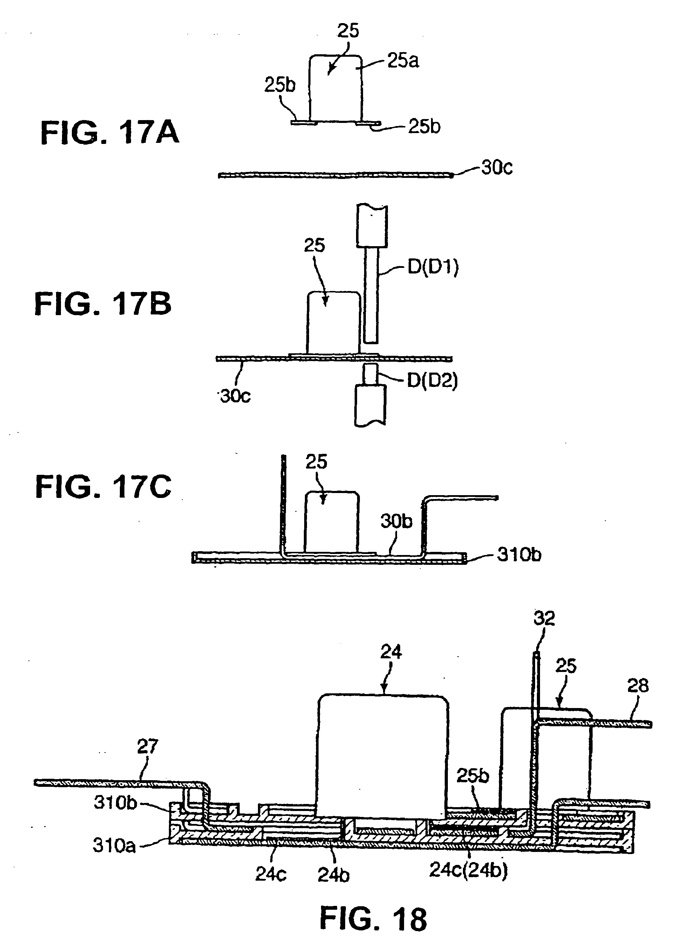

Next, the second relay 25 is mounted on the bus bar 22 on the third bus bar layer 30c. The third bus bar layer 30c is stacked on the second insulation plate 310b (see Figures 17A to 17C). Specifically, the contact piece 25c of the second relay 25 is superposed on the given bus bar 22 in the bus bar assembly corresponding to the third bus bar layer 30c. The electrodes D for resistance welding clamp the contact piece 25c and the bus bar 22 to join the leg-like terminal 25b of the second relay 25 to the given bus bar 22 by resistance welding.

As shown in Figure 17c, the given bus bars 22 of the bus bar assembly corresponding to the third bus bar layer 30c are bent to form the terminal 27 and 28. The bus bar assembly corresponding to the third bus bar layer 30c is installed on the second insulation plate 310b from an upper position. The connecting portions between the bus bars 22 and the outer frame on the bus bar assembly are cut off. The third bus bar layer 30c is stacked on the second insulation plate 310b.

Finally, the stacked assembly including the second insulation plate 310b and the third bus bar layer 30c is stacked on the stacked assembly including the first insulation plate 310a and the first and second bus bar layers 30a and 30b to cover the leg-like terminals 24b of the first relay 24 at the upper part thereof (covering step). Then, the bus bar substrate 20 mounting the first and second relays 24 and 25 thereon is produced. To be more specific, the relay body 24a of the first relay 24 has been already mounted on the stacked assembly including the first insulation plate 31a and the first and second bus bar layers 30a and 30b. The relay body 24a is inserted into the body receiving-aperture 315 in the second insulation plate 310b. Both staked assemblies are stacked on each other so that the second insulation plate 310b covers the leg-like terminal 24b of the first relay 24 at the upper portion thereof in conjunction with the pin-like terminal 32 standing on the first bus bar layer 30a is inserted into the pin receiving-aperture (not shown) in the second insulation plate 310b.

In the bus bar substrate 20 mounting the respective relays 24 and 25, as shown in Figure 18, the second insulation plate 310b is stacked on the leg-like terminal 24b of the first relay 24 to cover the upper part of the leg-like terminal 24b and also cover the first terminal receiving-aperture 311 in the first insulation plate 310a. The third bus bar layer 30c is disposed on the second insulation plate 310b to prevent a short circuit between the layers.

That is, in the circuit assembly 200 including the bus bar unit 20 on which the respective relays 24 and 25 are mounted and the distribution unit 1 installing the circuit assembly 200, because the bus bar layers 30a to 30c are stacked through the insulation plates 31a and 31 b by the same manner as the first embodiment, the second embodiment can reduce an occupation area of the electrical power circuit in comparison with a electrical power circuit constructed by a single bus bar layer. Further, because the first relay 24 that is highest in the circuit components is joined to the bus bars 22 on the first and second bus bar layers 30a and 30b below the uppermost third bus bar layer 30c and the contact piece 24c of the leg-like terminal 24b of the first relay 24 is joined to the bus bar 22, a dimension in height can be dramatically reduced in comparison with a prior art circuit assembly and distribution unit in which tab terminals are joined to each other.

In addition, even if the first relay 24 is mounted on the first and second bus bar layers 30a and 30b below the uppermost third bus bar layer 30c, because the connected portion between the bus bars 22 on the respective bus bar layers 30a and 30b and the contact piece 24c of the first relay 24 is covered by the second insulation plate 310b, it is possible to dispose the bus bar on the third bus bar layer 30c above the connected portion, thereby widening an arrangement area of the bus bar on the uppermost third bus bar layer 30c. Accordingly, the circuit assembly 200 can be further downsized by effectively arranging the bus bar 22 on the uppermost third bus bar layer 30c and also to downsize the distribution unit 1.

Although the circuit assembly and the like are described in the first and second embodiments, it should be noted that the circuit assembly and the like in accordance with the invention are not limited to the above embodiments. For example, the following alterations can be adopted.
(1) Although the above embodiments adopted the relays 24 and 25 as circuit components to be joined to the bus bar 22 on a layer lower than the uppermost layer, the circuit components to be joined to the lower layer are not limited to the relays. For example, they may be semiconductor switching-devices. However, a problem of thermal management in the respective circuit components will result from a high density in arrangement of the circuit components in association with downsizing of the circuit assembly. In the case where switching parts as the circuit components are used for an on-off switching operation of a circuit, it will be preferable to use a relay that is large in size in itself and has large heat capacity and high heat radiative characteristics.
(2) Although the first relay 24 as a circuit component is mounted on the respective bus bars 22 on the lowermost first bus bar layer 30a and the intermediate second bus bar layer 30b, the first relay 24 may be mounted on both of the first bus bar layer 30a and the uppermost third bus bar layer 30c as well as the same level layers.

## Claims

1. A circuit assembly (2) comprising:
a bus bar substrate (20); and
a circuit component (24), wherein said bus bar substrate (20) includes an electrical power circuit in which plural bus bar layers (30,30a,30b,30c) are stacked alternately through electrical insulation layers (31a, 31b, 31c) at plural levels, each of the bus bar layers (30) has plural bus bars (22) arranged on a substantially same plane, and the circuit component (24) including leg-like terminals (24b) and being connected to the electrical power circuit through said terminals (24b), and
each of said terminals (24b) having at least one contact piece (24c) to be superposed on one of the bus bars (22) along one of the layers (30) of the bus bars (22), and the contact piece (24c) of at least one of the terminals (24b) being joined by welding to a bus bar on a bus bar layer lower than the uppermost bus bar layer **characterized by** one of said insulation layers being stacked on the bus bar layer (30a, 30b) lower than the uppermost bus bar layer (30c) to cover over the contact piece (24c) of the terminal (24b) joined to the bus bar (22) on the bus bar layer lower than the uppermost bus bar layer, and
another bus bar (22) different from the bus bar on which the contact piece is joined being disposed on the insulation layer stacked on the bus bar layer lower than the uppermost bus bar layer.

2. The circuit assembly (2) according to claim 1, wherein the circuit component (24) includes a component body (24a) and leg-like terminals (24b) extending from a lower surface of the component body toward the bus bar, and a given portion of each leg-like terminal being bent in a direction parallel to one of the bus bar layers (30) to form the contact piece (24c).

3. The circuit assembly (2) according to claim 1 or 2, wherein the contact piece (24c) joined by resistance welding on the bus bar on the bus bar layer lower than the uppermost bus bar layer being joined to the bus bar.

4. The circuit assembly (2) according to anyone of claims 1 to 3, wherein the circuit component (24) is a relay.

5. The circuit assembly (2) according to anyone of claims 1 to 4, wherein the contact piece (24c) being disposed on each of the terminals (24b), the bus bar layers (30), on which the contact pieces (24c) are superposed, including different circuit components (24) and the height between the contact pieces (24c) of one of the circuit components (24) defining a stepped portion corresponding to the height between the bus bar layers (30) on which the contact pieces (24c) are superposed.

6. A distribution unit comprising a circuit assembly (2) according to anyone of claims 1 to 5 and a heat radiation casing (6,7) that contains the circuit assembly (2).

7. A method for producing a circuit assembly (2) that comprises a bus bar substrate (20) and a circuit component (24), wherein the bus bar substrate (20) includes an electrical power circuit in which plural bus bar layers (30) are stacked alternately through electrical insulation layers at plural levels, each of the bus bar layers (30) has plural bus bars (22) arranged on the substantially same plane, and the circuit component (24) including leg-like terminals (24b) including contact pieces (24c) and being connected to the electrical power circuit through said terminals (24b), the method comprising:
a bus bar layer forming step for forming the bus bar layers (30) individually;
a terminal joining step for joining one subset of the contact pieces (24c) of the circuit components (24) to the bus bars (22) on the bus bar layers (30) formed by the bus bar layer forming step by means of welding, the circuit components (24) being joined with the bus bars (22) along one of the bus bar layers (30) by the contact pieces (24c) of the leg-like terminals (24b);
a covering step for stacking the insulation layers to cover the joining portion of the contact pieces (24c) after the terminal joining step; and
an upper layer bus bar arranging step for arranging bus bars (22) on the upper surface of the insulation layer on which the subset of the contact pieces (24c) have been joined,
**characterized by** further comprising:
a stacking step for stacking a bus bar layer, on which the circuit component (24) is joined by the subset of the contact pieces (24c) in the terminal joining step, on an insulation layer disposed with terminal receiving-apertures for receiving the contact pieces (24c) that do not belong to the subset joined to the bus bar layer, so that the contact pieces (24c) that do not belong to the subset are inserted into the terminal receiving-apertures, after the terminal joining step and before the covering step; and
a remaining terminal joining step for joining the contact pieces (24c) that do not belong to the subset and are inserted into the terminal receiving-apertures to the bus bars (22) on one of the bus bar layers (30) formed by the bus bar layer forming step lower than the bus bar layer formed on the upper surface of the insulation layer by the upper layer bus bar arranging step.

8. The method for producing a circuit assembly (2) according to claim 7, wherein the contact pieces (24c) are joined by resistance welding.

9. The method for producing a circuit assembly (2) according to any one of claims 7 or 8, wherein the bus bar substrate (20) forming step includes:
a bus bar stacking step for stacking the plural bus bar layers (30) through the insulation layers alternately to form a bus bar substrate (20), and
wherein in the covering step plural insulation layers are formed, in the bus bar stacking step the terminal receiving-apertures in the insulation layers are brought into accord with one another and the insulation layers are stacked so that the bus bars (22) on the lower layer are exposed through the terminal receiving-apertures, and in the mounting step the contact piece (24c) of at least one terminal is joined to the bus bar on the lower layer.

10. The method for producing a circuit assembly (2) according to anyone of claims 7 to 9, wherein a relay is used as a circuit component (24).

## Patentansprüche

1. Eine Schaltkreisanordnung (2), die Folgendes aufweist:
ein Stromschienensubstrat (20); und
eine Schaltungskomponente (24), wobei das Stromschienensubstrat (20) eine elektrische Leistungsschaltung aufweist, in der mehrere Stromschienenschichten (30, 30a, 30b, 30c) abwechselnd mit elektrischen Isolierschichten (31 a, 31 b, 31 c) in mehreren Ebenen aufeinander gestapelt sind, wobei jede der Stromschienenschichten (30) mehrere Stromschienen (22) aufweist, die auf einer im Wesentlichen gleichen Ebene angeordnet sind, und die Schaltungskomponente (24) beinartige Anschlüsse (24b) aufweist und mit der elektrischen Leistungsschaltung durch die Anschlüsse (24b) verbunden ist, und
jeder der Anschlüsse (24b) mindestens ein Kontaktstück (24c) aufweist, das auf einer der Stromschienen (22) entlang einer der Schichten (30) der Stromschienen (22) überlagert ist, und das Kontaktstück (24c) mindestens eines der Anschlüsse (24b) durch Schweißen mit einer Stromschiene auf einer Stromschienenschicht verbunden ist, die tiefer als die oberste Stromschienenschicht liegt, **dadurch gekennzeichnet, dass** eine der Isolierschichten auf die Stromschienenschicht (30a, 30b) gestapelt ist, die niedriger als die oberste Stromschienenschicht (30c) ist, um das Kontaktstück (24c) des Anschlusses (24b) zu überdecken, das mit der Stromschiene (22) auf der Stromschienenschicht unter der obersten Stromschienenschicht verbunden ist, und
dass eine andere Stromschiene (22), die sich von der Stromschiene unterscheidet, auf welcher das Kontaktstück angebracht ist, auf der Isolierschicht angeordnet ist, die auf der Stromschienenschicht aufgestapelt ist, die tiefer als die oberste Stromschienenschicht liegt.

2. Die Schaltkreisanordnung (2) nach Anspruch 1, wobei die Schaltungskomponente (24) einen Komponentenkörper (24a) und beinartige Anschlüsse (24b) aufweist, die sich von einer unteren Oberfläche des Komponentenkörpers hin zu der Stromschiene erstrecken, und wobei ein gegebener Abschnitt jedes beinartigen Anschlusses in eine Richtung parallel zu einer der Stromschienen (30) gebogen ist, um das Kontaktstück (24c) zu bilden.

3. Die Schaltungsanordnung (2) nach Anspruch 1 oder 2, wobei das Kontaktstück (24c), das durch Widerstandsschweißen auf die Stromschiene auf der Stromschienenschicht, welche tiefer als die oberste Stromschienenschicht liegt, mit der Stromschiene verbunden ist.

4. Die Schaltungsanordnung (2) nach einem der Ansprüche 1 bis 3, wobei die Schaltungskomponente (24) ein Relais ist.

5. Die Schaltungsanordnung (2) nach einem der Ansprüche 1 bis 4, wobei das Kontaktstück (24c) auf jedem der Anschlüsse (24b) angeordnet ist, wobei die Stromschienenschichten (30), auf welchen die Kontaktstücke (24c) überlagert sind, verschiedene Schaltungskomponenten (24) aufweisen, und wobei die Höhe zwischen den Kontaktstücken (24c) einer der Schaltungskomponenten (24) einen gestuften Abschnitt definiert, welcher der Höhe zwischen den Stromschienenschichten (30) entspricht, auf welchen die Kontaktstücke (24c) überlagert sind.

6. Eine Verteilungseinheit, die eine Schaltungsanordnung (2) nach einem der Ansprüche 2 bis 5 und ein Wärme abstrahlendes Gehäuse (6, 7) aufweist, welches die Schaltungsanordnung (2) enthält.

7. Ein Verfahren zum Erzeugen einer Schaltungsanordnung (2), die ein Stromschienensubstrat (20) und eine Schaltungskomponente (24) aufweist, wobei das Stromschienensubstrat (20) eine elektrische Leistungsschaltung aufweist, in der mehrere Stromschienenschichten (30) abwechselnd über elektrische Isolierschichten in verschiedenen Ebenen gestapelt sind, wobei jede der Stromschienenschichten (30) mehrere Stromschienen (22) aufweist, die im Wesentlichen auf derselben Ebene angeordnet sind, und die Schaltungskomponenten (24) beinähnliche Anschlüsse (24b) aufweisen, welche Kontaktstücke (24c) umfassen und mit der elektrischen Leistungsschaltung durch die Anschlüsse (24b) verbunden sind, wobei das Verfahren folgende Schritte aufweist:
einen Schritt zum Bilden der Stromschienenschichten, um die Stromschienenschichten (30) einzeln zu bilden;
einen Anschlussverbindungsschritt, um einen Teil der Kontaktstücke (24c) der Schaltungskomponenten (24) mit den Stromschienen (22) auf den Stromschienenschichten (30), die durch den Schritt zum Bilden der Stromschienenschichten gebildet werden, mittels Schweißen zu verbinden, wobei die Schaltungskomponenten (24) mit den Stromschienen (22) entlang einer der Stromschienenschichten (30) durch die Kontaktstücke (24c) der beinähnlichen Anschlüsse (24b) verbunden sind;
einen Abdeckschritt, um die Isolierschichten aufeinander zu stapeln, um den Verbindungsabschnitt der Kontaktstücke (24c) nach dem Anschlussverbindungsschritt abzudecken; und
einen Schritt zur Anordnung einer Stromschiene auf der oberen Ebene zum Anordnen von Stromschienen (22) auf der oberen Oberfläche der Isolierschicht, auf welcher der Teil der Kontaktstücke (24c) verbunden wurde, **dadurch gekennzeichnet, dass** es weiterhin folgende Schritte aufweist:
einen Stapelschritt zum Aufstapeln einer Stromschienenschicht, auf welcher die Schaltungskomponente (24) mit dem Teil der Kontaktstücke (24c) im Anschlussverbindungsschritt verbunden ist, auf eine Isolierschicht, die mit anschlussaufnehmenden Öffnungen versehen ist, um die Anschlussstücke (24c) aufzunehmen, die nicht zu dem Teil gehören, der mit der Stromschienenschicht verbunden ist, so dass die Kontaktstücke (24c), die nicht zu dem Teil gehören, nach dem Anschlussverbindungsschritt und vor dem Abdeckschritt in die anschlussaufnehmenden Öffnungen eingefügt werden; und
einen Schritt des Verbindens verbleibender Anschlüsse, um die Anschlussstücke (24c), die nicht zu dem Teil gehören und in die anschlussaufnehmenden Öffnungen eingeführt werden, mit den Stromschienen (22) auf einer der Stromschienenschichten (30) zu verbinden, die durch den Schritt zum Bilden der Stromschienenschichten unter der Stromschienenschicht gebildet werden, die auf der oberen Oberfläche der Isolierschicht durch den Schritt zur Anordnung der Stromschiene auf der oberen Schicht gebildet ist.

8. Das Verfahren zum Erzeugen einer Schaltungsanordnung (2) nach Anspruch 7, wobei die Kontaktstücke (24c) durch Widerstandsschweißen verbunden sind.

9. Das Verfahren zum Erzeugen einer Schaltungsanordnung (2) nach einem der Ansprüche 7 oder 8, wobei der Schritt zum Bilden des Stromschienensubstrats (20) Folgendes aufweist:
einen Stromschienenstapelschritt zum abwechselnden Stapeln der mehreren Stromschienenschichten (30) über Isolierschichten, um ein Stromschienensubstrat (20) zu bilden, und
wobei in dem Abdeckschritt mehrere Isolierschichten gebildet werden, in dem Stromschienenstapelschritt die anschlussaufnehmenden Öffnungen in den Isolierschichten aufeinander gebracht werden, und die Isolierschichten so aufgestapelt sind, dass die Stromschienen (22) auf der unteren Schicht durch die anschlussaufnehmenden Öffnungen frei liegen, und in dem Montageschritt das Kontaktteil (24c) mindestens eines Anschlusses mit der Stromschiene auf der unteren Schicht verbunden wird.

10. Das Verfahren zum Erzeugen einer Schaltungsanordnung (2) nach einem der Ansprüche 7 bis 9, wobei ein Relais als eine Schaltungskomponente (24) verwendet wird.

## Revendications

1. Circuit d'ensemble (2) comprenant :
un substrat de barre omnibus (20) ; et
un composant de circuit (24), dans lequel ledit substrat de barre omnibus (20) comporte un circuit électrique dans lequel plusieurs couches de barre omnibus (30, 30a, 30b, 30c) sont empilées en alternance à travers des couches d'isolation électrique (31a, 31b, 31c) à plusieurs niveaux, chacune des couches de barre omnibus (30) présente plusieurs barres omnibus (22) agencées sur un plan sensiblement identique, et le composant de circuit (24) comportant des bornes du type patte (24b) et étant connecté au circuit électrique par lesdites bornes (24b), et
chacune desdites bornes (24b) présentant au moins une pièce de contact (24c) à superposer sur une des barres omnibus (22) le long d'une des couches (30) des barres omnibus (22), et la pièce de contact (24c) d'au moins une des bornes (24b) étant reliée par soudage à une barre omnibus sur une couche de barre omnibus inférieure à la couche de barre omnibus la plus supérieure, **caractérisé en ce qu'**une desdites couches isolantes est empilée sur la couche de barre omnibus (30a, 30b) inférieure à la couche de barre omnibus la plus supérieure (30c) pour recouvrir la pièce de contact (24c) de la borne (24b) reliée à la barre omnibus (22) sur la couche de barre omnibus inférieure à la couche de barre omnibus la plus supérieure, et une autre barre omnibus (22) différente de la barre omnibus sur laquelle la pièce de contact est reliée étant disposée sur la couche isolante empilée sur la couche de barre omnibus inférieure à la couche de barre omnibus la plus supérieure.

2. Ensemble de circuit (2) selon la revendication 1, dans lequel le composant de circuit (24) comporte un corps de composant (24a) et des bornes de type patte (24b) s'étendant depuis une surface inférieure du corps de composant en direction de la barre omnibus, et une partie donnée de chaque borne du type patte étant fléchie dans une direction parallèle à une des couches de barre omnibus (30) pour former la pièce de contact (24c).

3. Ensemble de circuit (2) selon la revendication 1 ou 2, dans lequel la pièce de contact (24c) reliée par soudage par résistance sur la barre omnibus sur la couche de barre omnibus inférieure à la couche de barre omnibus la plus supérieure est reliée à la barre omnibus.

4. Ensemble de circuit (2) selon l'une quelconque des revendications 1 à 3, dans lequel le composant de circuit (24) est un relais.

5. Ensemble de circuit (2) selon l'une quelconque des revendications 1 à 4, dans lequel la pièce de contact (24c) est disposée sur chacune des bornes (24b), les couches de barre omnibus (30), sur lesquelles les pièces de contact (24c) sont superposées, comportant différents circuits de composant (24) et la hauteur entre les pièces de contact (24c) d'un des composants de circuit (24) définissant une partie étagée correspondant à la hauteur entre les couches de barre omnibus (30) sur lesquelles les pièces de contact (24c) sont superposées.

6. Unité de distribution comprenant un ensemble de circuit (2) selon l'une quelconque des revendications 1 à 5 et un carter de radiation calorifique (6, 7) qui contient l'ensemble de circuit (2).

7. Procédé de production d'un ensemble de circuit (2) qui comprend un substrat de barre omnibus (20) et un composant de circuit (24), dans lequel le substrat de barre omnibus (20) comporte un circuit électrique dans lequel plusieurs couches de barre omnibus (30) sont empilées en alternance à travers les couches d'isolation électrique à plusieurs niveaux, chacune des couches de barre omnibus (30) présente plusieurs barres omnibus (22) agencées sur le plan sensiblement identique, et le composant de circuit (24) comportant des bornes du type patte (24b) comportant les pièces de contact (24c) et étant connecté au circuit électrique par lesdites bornes (24b), le procédé comprenant :
une étape de formation de couche de barre omnibus destinée à former les couches de barre omnibus (30) individuellement ;
une étape de liaison à la borne destinée à relier un sous-ensemble des pièces de contact (24c) des composants de circuit (24) aux barres omnibus (22) sur les couches de barre omnibus (30) formées par l'étape de formation de couche de barre omnibus au moyen d'un soudage, les composants de circuit (24) étant reliés aux barres omnibus (22) le long d'une des couches de barre omnibus (30) par les pièces de contact (24c) des bornes du type patte (24b) ;
une étape de recouvrement destinée à empiler les couches isolantes pour recouvrir la partie de liaison des pièces de contact (24c) après l'étape de liaison à la borne ; et
une étape d'agencement de barre omnibus de couche supérieure destinée à agencer les barres omnibus (22) sur la surface supérieure de la couche isolante sur laquelle le sous-ensemble des pièces de contact (24c) a été relié,
**caractérisé en ce qu'**il comprend en outre :
une étape d'empilement destinée à empiler une couche de barre omnibus, sur laquelle le composant de circuit (24) est relié par le sous-ensemble des pièces de contact (24c) au cours de l'étape de liaison à la borne, sur une couche isolante pourvue d'ouvertures de réception de borne destinées à recevoir les pièces de contact (24c) qui ne font pas partie du sous-ensemble relié à la couche de barre omnibus, de sorte que les pièces de contact (24c) qui ne font pas partie du sous-ensemble sont insérées à l'intérieur des ouvertures de réception de borne, après l'étape de liaison à la borne et avant l'étape de recouvrement ; et
une dernière étape de liaison à la borne destinée à relier les pièces de contact (24c) qui ne font pas partie du sous-ensemble et sont insérées à l'intérieur des ouvertures de réception de borne vers les barres omnibus (22) sur une des couches de barre omnibus (30) formées par l'étape de formation de couche de barre omnibus inférieure à la couche de barre omnibus formée sur la surface supérieure de la couche isolante par l'étape d'agencement de barre omnibus de couche supérieure.

8. Procédé de production d'un ensemble de circuit (2) selon la revendication 7, dans lequel les pièces de contact (24c) sont reliées par soudage par résistance.

9. Procédé de production d'un ensemble de circuit (2) selon l'une quelconque des revendications 7 à 8, dans lequel l'étape de formation de substrat de barre omnibus (20) comporte :
une étape d'empilement de barre omnibus destinée à empiler les diverses couches de barre omnibus (30) à travers les couches isolantes en alternance pour former un substrat de barre omnibus (20), et
dans lequel au cours de l'étape de recouvrement plusieurs couches isolantes sont formées, au cours de l'étape d'empilement les ouvertures de réception de borne dans les couches isolantes sont amenées à coïncider les unes avec les autres et les couches isolantes sont empilées de sorte que les barres omnibus (22) sur la couche inférieure sont exposées à travers les ouvertures de réception de borne, et au cours de l'étape de montage la pièce de contact (24c) d'au moins une borne est reliée à la barre omnibus sur la couche inférieure.

10. Procédé de production d'un ensemble de circuit (2) selon l'une quelconque des revendications 7 à 9, dans lequel un relais est utilisé comme composant de circuit (24).
